Europäisches Patentamt

European Patent Office

Office européen des brevets

(11) Veröffentlichungsnummer: **0 015 474**
A1

# (12) EUROPÄISCHE PATENTANMELDUNG

(21) Anmeldenummer: 80100930.9

(22) Anmeldetag: **25.02.80**

(51) Int. Cl.³: **F 21 K 2/00**
// G09F13/20, H01L31/02

(30) Priorität: **06.03.79 DE 2908770**

(43) Veröffentlichungstag der Anmeldung: **17.09.80**
**Patentblatt 80/19**

(84) Benannte Vertragsstaaten: **AT CH FR GB IT NL SE**

(71) Anmelder: **SIEMENS AKTIENGESELLSCHAFT Berlin
und München, Postfach 22 02 61,
D-8000 München 22 (DE)**

(72) Erfinder: **Quella, Ferdinand, Dr., Drygalski-Allee 118,
D-8000 München 71 (DE)**
Erfinder: **Pape, Heinz, Dipl.-Phys, Forstenrieder-Allee 17,
D-8000 München 71 (DE)**

(54) Verfahren zur Sammlung von Licht und Vorrichtung zur Durchführung eines solchen Verfahrens.

㊗ Vorzugsweise zur Bildaufhellung passiver Displays wird eine als Kollektor dienende Fluoreszenzplatte (FP) vorgeschlagen, die außer fluoreszierenden Partikeln einen zweiten Fluoreszenzfarbstoff enthält, der das schädliche UV-Licht absorbiert und so emittiert, daß dieses Licht von dem ersten Farbstoff absorbiert wird. Die verspiegelten Kerben (K) und die Streuelemente (S) sind durch farbige oder fluoreszierende Pigmente gebildet.

0015474

SIEMENS AKTIENGESELLSCHAFT
Berlin und München

Unser Zeichen
VPA .79 P 7 03 1

Verfahren zur Sammlung von Licht und Vorrichtung zur Durchführung eines solchen Verfahrens.

Die Erfindung betrifft ein Verfahren zur Sammlung von Licht mit einem als Lichtfalle wirkenden, vorzugsweise plattenförmig ausgebildeten Körper (Fluoreszenzkörper), der beispielsweise aus einem festen polymerisierten Kunststoffträger besteht, fluoreszierende Partikel (erster Fluoreszenzfarbstoff) enthält und mit mindestens einem Lichtaustrittsfenster versehen ist und eine Vorrichtung zur Durchführung eines solchen Verfahrens.

Ein solcher Kollektor ist bereits in mehreren Ausführungen bekannt und kann beispielsweise zum Einfangen von Sonnenenergie (P. W. Mauer und G. T. Turechek, Research Disclosure 29 (1975) 20, DE-OS 26 20 115 oder A. Götzberger und W. Greubel, Appl. Phys. 14 (1977) 123, zur optischen Übertragung von Nachrichten (Patentanmeldung P 27 42 899), zur Bildaufhellung passiver Displays (DE-OS 25 54 226 oder W. Greubel und G. Baur, Electronik 6 (1977) 55) oder zur Erhöhung der Empfindlichkeit von

Wed 1 Plr/1.3.1979

Szintillatoren (G. Keil, Nucl. Instr. and Meth. 87 (1970) 111) verwendet werden. Günstige Verarbeitungsbedingungen, Trägermaterialien und Möglichkeiten zur Verbesserung der Lichtausbeute sind bereits beschrieben, und zwar in den Patentanmeldungen P 28 33 914.2, P 28 33 926.6 und P 28 33 934.6.

Trifft Licht auf eine Fluoreszenzplatte, so wird der im Anregungsspektrum des Fluoreszenzstoffes liegende Anteil von den Fluoreszenzzentren absorbiert; der übrige Lichtanteil durchsetzt die Fluoreszenzplatte ungestört. Die absorbierte Strahlung wird - zu längeren Wellenlängen hin verschoben und räumlich ungerichtet - reemittiert. Von diesem Fluoreszenzlicht wird der weit überwiegende Teil durch (Total-) Reflexionen an den Plattengrenzflächen im Inneren der Trägerplatte fortgeleitet, bis er an bestimmten Auskoppelbereichen mit erhöhter Intensität austritt.

Die bisher mit Fluoreszenzplatten erzielten Wirkungsgrade bleiben noch immer deutlich hinter den theoretisch möglichen Werten zurück, und zwar vor allem deshalb, weil das Emissionsspektrum mit dem Absorptionsspektrum überlappt und daher die Fluoreszenzstrahlung der Platte eine endliche Absorptionslänge hat. Besonders unbefriedigend ist dabei, daß sich diese "Selbstabsorption" gerade bei Fluoreszenzkörpern mit großer Sammelfläche besonders ungünstig auswirkt.

Man weiß bereits seit längerem, daß bei vielen organischen Fluoreszenzstoffen das Emissionsband gegenüber dem Anregungsband zu niedrigeren Frequenzen hin verschoben wird, wenn diese Farbstoffe in einer Flüssigkeit mit einer starken Orientierungspolarisation gelöst werden. Eine solche Rotverschiebung tritt auf, wenn das fluoreszierende Molekül in seinem Grund- und Anregungszustand verschiedene Dipolmomente hat und wenn sich die Umgebung, die während des Absorptionsprozesses unverändert bleibt, während der Existenz des Anregungszustandes, umorientieren kann (E. Lippert, Z. Elektrochem.
Ber. Bunsenges. phys. Chem. $\underline{61}$ (1957) 962).

Fluoreszenzkörper sollen jedoch nach Möglichkeit aus einem
festen Trägermaterial bestehen. Denn feste Träger kann
man, insbesondere wenn es organische Kunststoffe sind,
mit relativ geringem Aufwand herstellen und verarbeiten,
ein Vorzug, der insbesondere bei Massenfertigungen stark
ins Gewicht fällt.

Daß auch in Festkörper-Lösungen die erwünschte Bandtrennung von der Dielektrizitätskonstanten des Lösungsmittels abhängt und hierbei die Dipolunterschiede im
Grund- und angeregten Zustand eine wichtige Rolle spielen,
wird bereits in der auf der Seite 123 von Appl. Phys. $\underline{14}$
(1977) 123 zitierten Arbeit erwähnt. Weiterführende Untersuchungen der angedeuteten Zusammenhänge, denen sich entnehmen ließe, wie man Kunststoffe mit den erforderlichen
Polarisationseigenschaften verwirklichen könnte, stehen
allerdings noch aus. Vor allem aber fehlt es an Hinweisen,
wie zu verfahren ist, damit die polaren Kunststoffe auch
die an Fluoreszenzkörper zu stellenden Forderungen erfüllen. Ein Fluoreszenzkörper muß bekanntlich hochtransparent und thermisch wie fotochemisch stabil sein,
sollte sich einfach in beliebige Formen bringen lassen,
hat im Endzustand hart und formbeständig zu sein und
sollte eine hohe Fluoreszenz-Quantenausbeute haben.

Der Erfindung liegt die Aufgabe zugrunde, mit möglichst
einfachen Mitteln einen Fluoreszenzkörper zu realisieren,
der im Vergleich zu dem bisher entwickelten Versionen
bei ansonsten ähnlich guten Eigenschaften eine deutlich
höhere Lichtausbeute und/oder eine deutlich höhere Lebensdauer hat und/oder eine Variation der emittierten Farbe gestattet.

Diese Aufgabe wird mit einem eingangs definierten Verfahren und einer Vorrichtung dadurch gelöst, daß durch einen zweiten Fluoreszenzfarbstoff ein Teil des Lichtes aus Bereichen kürzerer Wellenlänge in den Absorptionsbereich des ersten Fluoreszenzfarbstoffes verschoben wird.

Die Erfindung geht von der Überlegung aus, daß häufig nur ein Teil des zur Verfügung stehenden Umgebungslichtes (Sonnenlicht, Lampenlicht) für einen Anwendungszweck interessant ist. So werden z. B. bei einem "fluoreszenzaktivierten Display" (Greubel, Baur, Electronic $\underline{6}$ (1977) 55) die Farben gelb und gelbgrün vom Auge besonders gut erkannt. In vielen Fällen (z. B. Dämmerung, bedeckter Himmel) stehen jedoch im Absorptionsbereich nur geringe Mengen an Licht zur Verfügung.

Mit der Lösung nach der Erfindung wird erreicht, daß der Anteil des für die Helligkeit des Displays zur Verfügung stehenden Lichtes erhöht und die Lebensdauer verlängert wird. Dies geschieht in der Form, daß der zweite Fluoreszenzfarbstoff bei der kürzeren Wellenlänge absorbiert und seine Emissionsbande mit der Absorptionsbande des ersten Fluoreszenzfarbstoffes mehr oder weniger vollständig überlappt. Dem ersten Fluoreszenzfarbstoff steht so neben dem normalen absorbierbaren Licht aus der Umgebung noch das vom zweiten Fluoreszenzfarbstoff in seinen Absorptionswellenlängenbereich verschobene Licht zur Verfügung.

Nach einer Weiterbildung der Erfindung wird durch einen zweiten Fluoreszenzstoff, dessen Emissionsband zu einem wesentlichen Teil außerhalb des Absorptionsbereichs des ersten Farbstoffes liegt, die Helligkeit erhöht.

Nach einer weiteren Ausgestaltung der Erfindung hat der zweite Fluoreszenzfarbstoff dieselbe chemische Umgebung wie der erste Fluoreszenzfarbstoff (z. B. reines Trägermaterial oder polare Umgebung) oder ist damit verträglich und beeinträchtigt diesen nicht. Auf diese Weise ist eine ungestörte Durchmischung im Fluoreszenzplattenmaterial gegeben.

Die Konzentration eines jeden Fluoreszenzfarbstoffes wird gemäß der Erfindung so gewählt, daß das Licht aus den durch die Farbstoffe zu absorbierenden Wellenlängenbereichen des Umgebungslichtes jeweils zu 90 bis 100 % absorbiert wird. Damit wird erreicht, daß eine vollständige Ausnützung des Umgebungslichtes für die Fluoreszenzplatte zustandekommt und andererseits die selbsttätige Löschung möglichst klein gehalten wird. Es ist in diesem Falle vorteilhaft, daß die Farbstoffmoleküle des zweiten Farbstoffes für den ersten Lichtquellen darstellen, die gleichmäßig im Träger verteilt sind. Dadurch wird der Effekt der "Lichtaufzehrung", der normalerweise bei wachsendem Abstand von der Oberfläche der Platte eintritt, absolut gegenüber herkömmlichen Platten vermindert.

Nach einer Weiterbildung der Erfindung werden die einzustellenden Farbstoffkonzentrationen von dem Laufweg des Lichtes in der Platte und von der Lebensdauer der Farbstoffe abhängig gemacht. Falls die Zerfallsprodukte des Farbstoffes keine wesentliche Beeinträchtigung der optischen Eigenschaften des Systems bewirken, läßt sich die Konzentration eines der beiden Farbstoffe bis zur beginnenden Selbstlöschung der Fluoreszenz erhöhen. Dadurch wird die Lebensdauer der Fluoreszenzplatte trotz ständigen Zerfalls des Farbstoffes erhöht.

Eine Durchmischung der Farbstoffe im selben Träger ist nicht möglich. Nach einer weiteren Ausgestaltung der Erfindung kann der zweite Fluoreszenzfarbstoff in das Trägermaterial unter Änderung möglicher Zusatzstoffkomponenten oder in einen anderen Träger eingebettet werden. Das hat den Vorteil, daß man an den zweiten Träger keine besonders hohen optischen Anforderungen stellen muß und daß man Farbstoffe kombinieren kann, die sonst in einer Schicht unverträglich sind.

Der Ausdruck "Platte" oder "Fluoreszenzplatte" soll keine Einschränkung der Geometrie des Körpers beinhalten.

Die zweite Schicht bewirkt, daß die einfallende Lichtintensität in dem Wellenlängenbereich, der vom Fluoreszenzstoff in der Platte absorbiert wird, auf Kosten kürzerer Wellenlängen erhöht wird. Selbstverständlich muß das Trägermaterial für den Hilfsfarbstoff möglichst hochtransparent-zumindest für die Absorptionsbande des primären Fluoreszenzfarbstoffes-sein.

Dennoch sind die Anforderungen an die optische Qualität des zweiten Trägermaterials nicht so hoch wie für das Material der eigentlichen ersten Fluoreszenzplatte, da man die Schichtdicke und damit den Weganteil des teilweise mehrfach total reflektierten Lichtes in einem optisch weniger günstigen Medium sehr klein machen kann.

Reicht die Transmission in den Wellenlängenbereichen der Absorption beider Fluoreszenzfarbstoffe aus, so finden gemäß weiterer Erfindung für die zusätzliche Schicht auch Materialien mit einem Brechungsindex $n \approx 1$ Verwendung. In diesem Fall läuft das total reflektierte Licht fast nur in der Display-Farben-Platte, wobei an Auskoppelstellen die zweite Schicht entfernt wird. Durch die Verwendung von Materialien für die zusätzliche Schicht mit einem Brechungsindex $n \approx 1$ erweitert sich die Zahl der ausnützbaren Trägermaterialien aus dem Bereich der Kunststoffe, Glas usw.

Neben dem zusätzlichen Helligkeitsgewinn bei Displays hat diese Anordnung den Vorteil, daß man im Falle der Energieumwandlung beim Einfangen von Sonnenenergie (s. z. B. A. Götzberger, W. Greubel, Appl. Phys. 14 (1977) 123) mit wenigen verschiedenen Farbstoffträgern oder wenigen Sonnenzellen auskommt, um den gesamten Bereich des Sonnenlichtspektrums zu erfassen.

Die vorgeschlagene Anordnung wird auch dadurch interessant, daß zur Ausnutzung des gesamten Sonnenlichtspektrums geeignete Sonnenzellen noch nicht angeboten werden bzw. technisch noch nicht ausgereift sind. Bisher werden technisch hauptsächlich Siliziumzellen eingesetzt. Verschiebt man also noch zusätzliche Bereiche des Sonnenlichtspektrums in den Arbeitsbereich dieser Sonnenzellen, so müßte sich der Energiegewinn beträchtlich steigern lassen.

Bei den für die Farbstoffe verwendeten Trägerwerkstoffen kennt man das Phänomen, daß sich Absorptions- und Emissionsbande eines Fluoreszenzfarbstoffes überlappen und daß durch Eigenabsorption im Überlappungsbereich Licht verlorengeht. In den Patentanmeldungen P 28 33 914, P 28 33 926 und P 28 33 934 wurden Methoden zur Trennung von Absorptions- und Emissionsbande durch Einbettung des Farbstoffes in eine polare Umgebung angegeben. Besonders dann, wenn der polare Zusatz eine hohe Viskosität besitzt, wurde eine erhebliche Zunahme der Ausbeute an Emissionslicht erreicht (K. H. Drexhage, "Structure and Properties of Laser Dyes", in F. P. Schäfer (Ed.), "Dye Lasers", Springer Verlag 1973, S. 173). Da zumischen polarer Zusätze jedoch einen erheblichen Aufwand bedeutet, dürfte es in einigen Fällen genügen, wenn man das Gesamtangebot an Licht im interessanten Bereich nur durch Zusatz eines zweiten Farbstoffes (ohne polaren Zusatz) erhöht. Der durch Selbstabsorption verlorene Emissionslicht-Anteil wird dann durch das zusätzliche Lichtangebot aufgewogen.

Nach einer Weiterbildung der Erfindung wird ein Trägerwerkstoff verwendet, der eine Lichtdurchlässigkeit im
UV-Bereich besitzt. Einige Typen von käuflichem, technischem PMMA (Polymethylmethacrylat) stellen einen solchen
Trägerwerkstoff dar. Seine Durchlässigkeit für UV-Licht
beginnt bei Wellenlängen $>$ 250 nm.

Licht mit Wellenlängen $\leq$ 400 nm gilt als äußerst schädlich für Farbstoffe und Trägerwerkstoffe und führt zu
einer raschen Alterung der Anordnung. Nach der Erfindung
wird die Konzentration des zweiten Fluoreszenzfarbstoffes so gewählt, daß er im Bereich zwischen 250 und
400 nm möglichst stark absorbiert. Auf diese Weise
kommt dem zweiten zugesetzten Fluoreszenzfarbstoff noch
die Funktion eines Alterungsschutzmittels (technisch
bekannt als UV-Absorber) zu.

Der UV-Schutz ist nicht nur gegen die zerstörerische
Wirkung des UV-Lichtes (Kettenspaltung), sondern auch
gegen Oxidationswirkungen auf Farbstoff und Träger wirksam. UV-Licht ($\lambda \leq$ 400 nm) bewirkt bei dem immer vorhandenen Sauerstoff energiereiche, stark oxidierende Anregungszustände, die durch den UV-Schutz weitgehend
vermieden werden. Im Rahmen der Erfindung werden dem
Trägerwerkstoff daher neben dem UV-Schutz auch Mittel
zum Oxidationsschutz zugemischt. Die Mittel zum UV-Schutz
bzw. zum Oxidationsschutz und deren Reaktionsprodukte
mit Sauerstoff sind für das Emissionslicht durchlässig.
Für den Oxidationsschutz kommen Sauerstoffquencher in
Form von z. B. tertiären Aminen, vorzugsweise Diazabicyclooctan, in Frage.

Nach einer Weiterbildung der Erfindung ist der Oxidationsschutz zugleich ein polares Lösungsmittel für den Farbstoff. Dadurch kann man die Absorptions- und Emissionsbande der Farbstoffe besser trennen.

Da der zweite Fluoreszenzfarbstoff dieselbe chemische Umgebung wie der erste benötigt, oder zumindest damit verträglich sein muß und ihn nicht beeinträchtigen darf,
wählt man die Konzentration des zweiten zusätzlichen
Fluoreszenzfarbstoffes möglichst so hoch, daß das UV-Licht
bereits in Oberflächennähe (geringe Eindringtiefe) völlig
absorbiert wird.

Wie bereits ausgeführt ist eine Durchmischung der Farbstoffe im selben Träger nicht möglich, aber eine Einbettung des Hilfsfarbstoffes in das Trägermaterial unter
Änderung möglicher Zusatzstoffkomponenten in einen
anderen Träger möglich. Dies gilt auch dann, wenn die
hohe Konzentration des zweiten Fluoreszenzstoffes eine
Störung der optischen Eigenschaften oder des primären
Farbstoffes bewirkt, die Trägerzusammensetzung aber
dennoch identisch ist.

Nach einer Weiterbildung der Erfindung überlappen sich
die Emissionsbande des zweiten Fluoreszenzfarbstoffes
und die Absorptionsbande des ersten Fluoreszenzfarbstoffes nicht, so daß aus zwei Fluoreszenzfarben eine
Mischfarbe entsteht, die vom Anteil des jeweiligen
Emissionslichtes an der Gesamtintensität abhängt.

Nach einer weiteren Ausbildung der Erfindung wird der
Farbton der Fluoreszenzplatte durch das Mischungsverhältnis der Farbstoffe variiert. Außerdem kann das
Fluoreszenzlicht durch farbige, fluoreszierende oder
nicht fluoreszierende Pigmente ausgekoppelt werden. Auch
hierdurch ist eine Farbvariation zu erreichen. Farbe und Intensität des ausgekoppelten Lichtes zu variieren ist auch möglich, wenn keinerlei Überlappung von Emissionsbande des einen und Absorptionsbande des anderen Farbstoffes vorliegt, da auch die Addition der beiden emittierten Fluoreszenzfarben eine Erhöhung der Gesamtintensität des Fluoreszenzlichtes darstellt.

Eine Vorrichtung zur Durchführung eines Verfahrens mit einer Fluoreszenzplatte, die an ihrer Deckfläche reflektierende Stellen (z. B, Kerben) und an der gegenüberliegenden Fläche lichtstreuende Elemente aufweist, besteht nach einer Weiterbildung der Erfindung darin, daß die reflektierenden Stellen durch aufgedruckte Pigmente (z. B. farbig oder fluoreszierend) gebildet sind. Als Streuelemente sind ferner ebenfalls farbige oder fluoreszierende Pigmente vorgesehen. Darüber hinaus sind am Plattenrand fluoreszierende Pigmente zur Veränderung des Farbtones des Fluoreszenzlichtes eingebracht.

Als zweite Zusatzfluoreszenzstoffe kommen vor allem solche in Frage, wie sie üblicherweise als "Weißmacher" und optische Aufheller (z. B. A. Wagner, Naturwissenschaften 55 (1968) 533 - 538) Verwendung finden. Diese lassen von ihrem Absorptions- und Emissionsverhalten her im sichtbaren Spektrum noch genügend Raum für einen zweiten Fluoreszenzstoff.

Folgende organische Kunststoffe sollten zweckmäßigerweise als Trägerwerkstoffe verwendet werden: Polyacrylate, Polymethacrylate, Polystyrole, ebenso Copolymere mit Methacrylaten und Styrolen als Hauptkomponente, Cellulosederivate, wie z. B. Celluloseacetybutyrat, und Silikone mit Polaran Gruppen.

Der Fluoreszenzkörper einer erfindungsgemäßen Vorrichtung kann auf verschiedene Weise hergestellt werden. Am rationellsten arbeitet man mit einem Spritzgußverfahren oder einer Extrudiertechnik oder aber man vergießt den Körper. Dabei können die polaren Zusätze entweder mit einem unvernetzten (thermoplastischen) Polymeren, etwa in einem Extruder, gemischt werden; oder man mischt die Zusätze mit dem Monomeren und polymerisiert anschließend die Mischung. Stellt man den Körper durch eine Gießtechnik her, dann braucht das Polymer nicht thermoplastisch zu sein; es kann also, wie dies bei Gießharzen der Fall ist, bei der Polymerisation vernetzen.

Einige wenige Polymer/Zusatz-Paarungen mischen sich zwar bei höheren Temperaturen gut, neigen aber beim langsamen Abkühlen dazu, in einer oder beiden Komponenten teilweise auszukristallisieren. Dem kann entgegengewirkt werden, indem man die Mischung von hoher Temperatur rasch auf niedrige Temperaturen bringt, so daß ein amorpher Glaszustand eingefroren wird. Ein solcher Abschreckungsprozeß vollzieht sich beispielsweise automatisch beim Verarbeiten auf Spritzgußmaschinen, wo die Form meist bei einer Temperatur um ca. 60° C gehalten wird.

Die in der geschilderten Weise hergestellten Endprodukte liegen in folgenden Modifikationen vor: Es sind entweder thermoplastische Kunststoffe mit polaren organischen Zusätzen in gelöster oder chemisch gebundener Form oder aber vernetzte thermoplastische Kunststoffe mit polaren organischen Zusätzen, die ebenfalls gelöst oder chemisch gebunden sind.

Die Erfindung wird anhand der Figuren erläutert. Es zeigen:

Figur 1 einen schematisierten Seitenschnitt einer Lichtsammelvorrichtung und

Figur 2 den prinzipiellen Aufbau eines herkömmlichen
fluoreszenzaktivierten Displays.

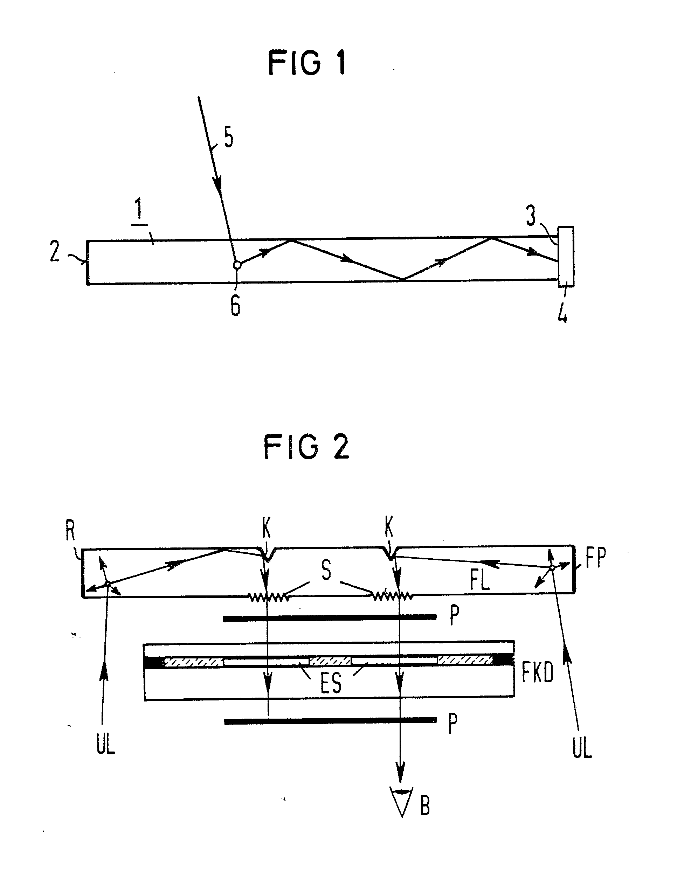

In der Figur 1 ist eine Fluoreszenzplatte 1 dargestellt,
die an drei ihrer vier Schmalseiten jeweils mit einer Reflexionsschicht 2 versehen ist und an ihrer vierten
Schmalseite (Lichtaustrittsseite 3) eine Solarzelle 4
trägt. In dieser Figur ist der typische Weg eines im Anregungsspektrums der fluoreszierenden Partikel liegenden
Lichtstrahls eingezeichnet: Der mit 5 bezeichnete  Strahl
wird von einem Fluoreszenzzentrum 6 im Inneren der
Fluoreszenzplatte 1 absorbiert, reemittiert und mittels
Totalreflexionen durch die Lichtaustrittsseite 3 auf die
Solarzelle 4 geführt.

Das Umgebungslicht UL in der Figur 2 wird in der Floreszenzplatte FP von einem Farbstoffmolekül absorbiert und
Fluoreszenzlicht FL wird emittiert. Aufgrund der Totalreflexion und der Randverspiegelung R bleibt der größte
Teil des Fluoreszenzlichtes in der Platte FP eingesperrt.
Nur an den eingekerbten Stellen K, die mit einem reflektierenden Überzug versehen sind, wird das Licht so umgelenkt, daß es auf der gegenüberliegenden Plattenseite
die Platte verlassen kann. Geometrisch den Kerben angepaßt befinden sich in dieser Oberfläche lichtstreuende
Elemente S, die zur Vergrößerung des Beobachtungswinkels
dienen. Zwischen Fluoreszenzplatte FP und Beobachter B
befinden sich eine übliche LCD-Anzeige bestehend aus zwei
Polarisatoren P und dem Flüssigkristalldisplay FKD mit
den Elektrodensegmenten ES, die geometrisch auf die
Kerben K und Streuflächen S abgestimmt sind.

Die Erfindung ist nicht auf die beschriebenen und dargestellten Ausführungsbeispiele beschränkt. Insbesondere
kann man den Fluoreszenzkörper auch anders als streng
plattenförmig gestalten, wenn man dafür sorgt, daß die Lichtfallenwirkung aufgrund von Totalreflexionen gewahrt bleibt. Geeignete Körperausbildungen sind beispielsweise in der Patentanmeldung P 27 24 748 beschrieben.


20 Patentansprüche
 2 Figuren

Patentansprüche.

1. Verfahren zur Sammlung von Licht mit einem als Lichtfalle wirkenden, vorzugsweise plattenförmig ausgebildeten Körper (Fluoreszenzkörper), der beispielsweise aus einem festen polymerisierten Kunststoffträger besteht, fluoreszierende Partikel (als 1. Fluoreszenzfarbstoff bezeichnet) enthält und mit mindestens einem Lichtaustrittsfenster versehen ist, d a d u r c h   g e -
k e n n z e i c h n e t ,   daß durch einen zweiten Fluoreszenzfarbstoff ein Teil des Lichtes aus Bereichen kürzerer Wellenlänge in den Absorptionsbereich des ersten Fluoreszenzfarbstoffes verschoben wird.

2. Verfahren nach Anspruch 1, d a d u r c h   g e - k e n n z e i c h n e t ,   daß der kurzwelligere Anteil des Fluoreszenzlichtes des 1. Fluoreszenzfarbstoffes durch einen 3. Fluoreszenzfarbstoff absorbiert und zu längeren Wellenlängen verschoben wird.

3. Verfahren nach Anspruch 1, d a d u r c h   g e - k e n n z e i c h n e t ,   daß durch einen zweiten Fluoreszenzfarbstoff, dessen Emissionsband zu einem wesentlichen Teil außerhalb des Absorptionsbereichs des ersten Farbstoffes liegt, die Helligkeit erhöht wird.

4. Verfahren nach Anspruch 1 bis 3, d a d u r c h   g e k e n n z e i c h n e t ,   daß der zweite Fluoreszenzfarbstoff dieselbe chemische Umgebung wie der erste Fluoreszenzfarbstoff (z. B. reines Trägermaterial oder polare Umgebung) hat oder zumindest damit verträglich ist.

5. Verfahren nach den Ansprüchen 1, 3 und 4, d a - d u r c h   g e k e n n z e i c h n e t ,   daß die Konzentration eines jeden Fluoreszenzfarbstoffes so gewählt wird, daß das Licht aus den durch die Farbstoffe zu absorbierenden Wellenlängenbereichen des Umgebungslichtes
jeweils zu 90 bis 100 % absorbiert wird.

6. Verfahren nach Anspruch 1 oder 2,  d a d u r c h
g e k e n n z e i c h n e t ,  daß die einzustellende
Farbstoffkonzentration von dem Laufweg des Lichtes in
der Platte und von der Lebensdauer des Farbstoffes abhängig gemacht wird.

7. Verfahren nach Anspruch 1 oder 2,  d a d u r c h
g e k e n n z e i c h n e t ,  daß der zweite Fluoreszenzfarbstoff unter Änderung der Zusatzstoffkomponenten
in das Trägermaterial eingebettet wird.

8. Verfahren nach Anspruch 7,  d a d u r c h  g e -
k e n n z e i c h n e t ,  daß der zweite Fluoreszenzfarbstoff in einen anderen Träger eingebettet wird.

9. Verfahren nach Anspruch 8,  d a d u r c h  g e -
k e n n z e i c h n e t ,  daß eine heterogene Struktur
aus der eigentlichen Fluoreszenzplatte und der zweiten
Schicht, in die der zweite Fluoreszenzstoff eingebettet
ist, hergestellt wird.

10. Verfahren nach Anspruch 8,  d a d u r c h  g e -
k e n n z e i c h n e t ,  daß für die zusätzliche
Schicht auch Materialien mit kleinem Brechungsindex bis
herab zu n $\approx$ 1 Verwendung finden.

11. Verfahren nach Anspruch 1 oder 2,  d a d u r c h
g e k e n n z e i c h n e t ,  daß der Trägerwerkstoff
eine Lichtdurchlässigkeit im UV-Bereich besitzt.

12. Verfahren nach Anspruch 1 oder 2,  d a d u r c h
g e k e n n z e i c h n e t ,  daß die Konzentration des zweiten Fluoreszenzfarbstoffes so gewählt ist, daß er im Bereich zwischen 250 und 400 nm nahezu vollständig absorbiert.

13. Verfahren nach Anspruch 1 oder 2, d a d u r c h g e k e n n z e i c h n e t , daß als Trägerwerkstoff für den Fluoreszenzkörper Cellulosederivate, z. B. Celluloseacetobutyrat, Polyacrylate, Polymethacdrylate, Polystyrole und Copolymere mit Styrol bzw. Methylmethacrylat als Hauptkomponente und Silikonharze mit polaren Gruppen, Verwendung finden.

14. Verfahren nach Anspruch 11, d a d u r c h g e - k e n n z e i c h n e t , daß dem Trägerwerkstoff neben dem UV-Schutz auch Mittel zum Oxidationsschutz zugemischt werden.

15. Verfahren nach Anspruch 14, d a d u r c h g e - k e n n z e i c h n e t , daß die Mittel zum UV-Schutz bzw. zum Oxidationsschutz und deren Reaktionsprodukte mit Sauerstoff für das Emissionslicht lichtdurchlässig sind.

16. Verfahren nach Anspruch 14, d a d u r c h g e - k e n n z e i c h n e t , daß der Oxidationsschutz zugleich ein polares Lösungsmittel für den Farbstoff darstellt.

17. Verfahren nach Anspruch 1, d a d u r c h g e - k e n n z e i c h n e t , daß als Zusatzfluoreszenzstoffe, vorzugsweise optische Aufheller, Verwendung finden.

18. Vorrichtung zur Durchführung eines Verfahrens nach den vorhergehenden Ansprüchen mit einer Fluoreszenzplatte, die an ihrer Deckfläche reflektierende Stellen (z. B. Kerben) und an der gegenüberliegenden Fläche lichtstreuende Elemente aufweist, d a d u r c h g e -
k e n n z e i c h n e t , daß die reflektierenden
Stellen (K) durch aufgedruckte Pigmente (z. B. farbig
oder fluoreszierend) gebildet sind.

19. Vorrichtung nach Anspruch 18, d a d u r c h g e -
k e n n z e i c h n e t , daß als Streulemente (S)
Pigmente (z. B. farbig oder fluoreszierend) vorgesehen
sind.

20. Vorrichtung nach Anspruch 18, d a d u r c h g e -
k e n n z e i c h n e t , daß am Plattenrand
fluoreszierende Pigmente zur Veränderung des Farbtones
des Fluoreszenzlichtes eingebracht sind.

## FIG 1

## FIG 2

0015474

Europäisches Patentamt

**EUROPÄISCHER RECHERCHENBERICHT**

Nummer der Anmeldung

EP 80 10 0930

| | EINSCHLÄGIGE DOKUMENTE | | KLASSIFIKATION DER ANMELDUNG (Int. Cl.) |
|---|---|---|---|
| Kategorie | Kennzeichnung des Dokuments mit Angabe, soweit erforderlich, der maßgeblichen Teile | betrifft Anspruch | |
| X | <u>US - A - 3 426 212</u> (B. KLAAS)<br>  * Ansprüche 1,7,10 * | 1-5,8,<br>11,17 | F 21 K 2/00 //<br>G 09 F 13/20<br>H 01 L 31/02 |
| | -- | | |
| X | <u>GB - A - 1 484 471</u> (L.A. GRAVISSE)<br>  * Ansprüche 1,2 * | 1 | |
| | -- | | |
| X | <u>FR - A - 2 346 858</u> (P. GRAVISSE)<br>  * Ansprüche 1,4,6,7 * | 1 | RECHERCHIERTE SACHGEBIETE (Int. Cl.) |
| | -- | | |
| | <u>FR - A - 2 329 736</u> (B.R.I.C.)<br>  * Ansprüche 1,2 * | 1 | F 21 K 2/00<br>H 01 J 61/42<br>C 09 K 11/00<br>H 01 L 31/02<br>G 02 F 1/133<br>G 09 F 13/20 |
| | -- | | |
| D | ELEKTRONIK, Band 26, Nr. 6, 1977,<br>W. GREUBEL et al.: "Das Fluor-<br>eszenz-Aktivierte Display "FLAD",<br>Seiten 55,56<br>  * Bild 1; Seite 56, rechte<br>    Spalte, Zeilen 15-29 * | 18,19 | |
| | -- | | |
| P | <u>US - A - 4 149 902</u> (B. MAUER et al)<br>  * Ansprüche 1,6 * | 1 | KATEGORIE DER GENANNTEN DOKUMENTE |
| | -- | | X: von besonderer Bedeutung<br>A: technologischer Hintergrund<br>O: nichtschriftliche Offenbarung<br>P: Zwischenliteratur<br>T: der Erfindung zugrunde liegende Theorien oder Grundsätze<br>E: kollidierende Anmeldung<br>D: in der Anmeldung angeführtes Dokument<br>L: aus andern Gründen angeführtes Dokument |
| AD | <u>DE - A - 2 620 115</u> (FRAUNHOFER GESELLSCHAFT)<br>  * Ansprüche 1-17; Bilder 1,2 * | 1,18 | |
| | ---- | | |
| | | | &: Mitglied der gleichen Patentfamilie, übereinstimmendes Dokument |
| | Der vorliegende Recherchenbericht wurde für alle Patentansprüche erstellt | | |

| Recherchenort | Abschlußdatum der Recherche | Prüfer |
|---|---|---|
| Den Haag | 11-06-1980 | V.D. BULCKE |

EPA form 1503.1 06.78